# EUROPÄISCHE PATENTSCHRIFT

(11) **EP 3 105 078 B1**
(45) Veröffentlichungstag und Bekanntmachung des Hinweises auf die Patenterteilung: **25.10.2017**
(21) Anmeldenummer: 15703223.6
(22) Anmeldetag: 28.01.2015
(51) Int. Cl.: B60K 1/00, B60L 1/08, H01L 23/34, H05K 7/20, B60K 11/02, B60H 1/00, F01P 3/00, B60L 1/00, F01P 7/14

(54) **VERFAHREN ZUR KÜHLUNG EINER KOMPONENTE EINES KRAFTFAHRZEUGS, KÜHLEINRICHTUNG UND KRAFTFAHRZEUG**
COOLING METHOD FOR A VEHICLE COMPONENT, COOLING APPARATUS AND VEHICLE
PROCÉDÉ DE REFROIDISSEMENT D'UN COMPOSANT DE VÉHICULE, DISPOSITIF DE REFROIDISSEMENT ET VÉHICULE

(30) Priorität: 12.02.2014 DE 102014001974
(43) Veröffentlichungstag der Anmeldung: 21.12.2016
(73) Patentinhaber: Audi AG, 85045 Ingolstadt (DE)
(72) Erfinder: MEITINGER, Karl-Heinz, 80639 München (DE)
(74) Vertreter: Askaryar, Jama
(86) Internationale Anmeldenummer: PCT/EP2015/000160
(87) Internationale Veröffentlichungsnummer: WO 2015/120958

(56) Entgegenhaltungen:
- WO-A1-2012/131459
- DE-A1-102004 035 879
- DE-A1-102009 057 163
- DE-A1-102011 107 540
- US-A1- 2004 250 995

## Beschreibung

Die Erfindung betrifft ein Verfahren zur Kühlung einer Komponente eines Kraftfahrzeugs, die thermisch mit einem mit einem flüssigen Kühlmittel gefüllten Kühlvolumen gekoppelt ist.

In Kraftfahrzeugen ist die Kühlung einer Vielzahl von Komponenten notwendig. Dabei ist mit der zunehmenden Nutzung von leistungsstarker Elektronik im Kraftfahrzeug, insbesondere zum Antrieb des Kraftfahrzeugs in einem Elektro- oder Hybridfahrzeug, zunehmend die Kühlung von Leistungselektronikkomponenten notwendig. Ferner werden rein elektrische Antriebe oder Hybridantriebe mittlerweile auch in sehr leistungsfähigen Kraftfahrzeugen genutzt, weshalb eine Bestromung und Steuerung von sehr leistungsstarken Elektromotoren im Kraftfahrzeug notwendig ist. Dabei werden zahlreiche Komponenten der Leistungselektronik, insbesondere Spannungswandler, aber auch diverse steuernde oder regelnde Bauteile, bei einer Vollbelastung des Motors von sehr hohen Strömen durchflossen und/oder es liegen sehr hohe Spannungen an ihnen an, wodurch selbst bei effizienten Komponenten eine große Abwärme entsteht, die abgeführt werden muss. Ein Kühlsystem für diese Komponenten muss derart ausgelegt sein, dass es auch bei einer maximalen an der Komponente umgesetzten Leistung eine ausreichende Kühlung der Komponente sicherstellt. Das Gleiche gilt dabei auch für mechanische Komponenten, insbesondere Komponenten eines Motors, bei denen im Verlauf des Fahrbetriebs deutlich unterschiedliche thermische Belastungen auftreten können.

Um stets eine ausreichende Kühlung sicherzustellen, muss die Kühlung der Komponente so ausgelegt sein, dass sie bei Maximallast für die Komponente eine ausreichende Kühlleistung bereitstellt. Insbesondere die Leistungselektronik zum Betrieb von leistungsstarken Elektroantrieben erfordert dabei groß dimensionierte Kühlsysteme. In diesen werden mehrere oder sehr starke Pumpen genutzt, um Kühlmittel mit einer hohen Flussgeschwindigkeit durch Bereiche zu pumpen, in denen ein Wärmeaustausch mit zu kühlenden Komponenten erfolgt. Dabei wird die durch diese Kühlsysteme maximal bereitgestellte Kühlleistung beim typischen Fahrbetrieb des Kraftfahrzeugs sehr selten genutzt. Bei einem Betrieb eines Kraftfahrzeugs im normalen Straßenverkehr wird die maximale Leistung des Kraftfahrzeugs von den meisten Fahrern nicht genutzt. Selbst wenn diese Maximalleistung genutzt wird, so wird sie typischerweise nur in einzelnen Situationen, wie beim Überholen oder Beschleunigen, für wenige Sekunden genutzt. Selbst bei einem sportlichen Fahrbetrieb, insbesondere auf geschlossenen Rennkursen oder ähnlichem, wird nicht stets die volle Leistung von Kraftfahrzeugkomponenten benötigt. Damit steht in den meisten Fahrsituationen unabhängig von der Art des Fahrbetriebs eine wesentlich größer Kühlleistung zur Verfügung als tatsächlich benötigt wird.

Aufgrund dieser für die meisten Fahrsituationen unnötig starken Kühlleistung belastet das Kühlsystem eines Kraftfahrzeugs das elektrische Bordsystem eines Kraftfahrzeugs unnötig stark und kann damit zur Leistungsreduzierung führen und insbesondere dazu, dass die Reichweite eines strombetriebenen Kraftfahrzeugs reduziert wird. Ein möglicher Ansatz, die Kühlleistung eines derartigen Kühlsystems anzupassen wäre es, die Pumpenleistung der einen oder mehreren Pumpen im Kühlkreislauf der Kühleinrichtung bei geringer benötigter Kühlleistung zu senken. Dabei ist jedoch problematisch, dass hochleistungsfähige Kühleinrichtungen in Kraftfahrzeugen typischerweise so ausgebildet sind, dass sie einen maximalen Wirkungsgrad nur erreichen, wenn Kühlmittel mit sehr hoher Geschwindigkeit durch das Kühlsystem gepumpt wird, um beispielsweise turbulente Strömungen in den Bereichen, in denen ein Wärmeaustausch mit den Komponenten stattfindet, zu ermöglichen. Eine hohe Wärmeübertragung ist dabei insbesondere notwendig, weil zu kühlende Leistungsbausteine häufig eine verhältnismäßig kleine Oberfläche und geringe thermische Trägheit aufweisen, so dass ein hoher Wärmeübergang häufig nur durch verwirbeltes und/oder schnell strömendes Kühlmittel erreicht werden kann. Eine Reduzierung der Kühlleistung würde in diesem Fall zu einem langsamer strömenden Kühlmittel und damit zu einem Sinken der Effizienz der Kühleinrichtung führen. Damit würde im Fall geringer Belastung eine relativ ineffiziente und damit energieaufwendige Kühlung der Komponente erreicht. DE102009057163 offenbart ein Verfahren zur Kühlung einer Fahrzeugkomponente, wobei die Komponente in einem ersten und zweiten Kühlmodus gekühlt wird. DE102004035879 offenbart ein Verfahren zur Kühlung einer Fahrzeugkomponente mit einem Kältekreislauf und einem Kühlkreislauf. Der Erfindung liegt damit die Aufgabe zugrunde, ein Verfahren zur Kühlung einer Komponente eines Kraftfahrzeugs anzugeben, das über ein weites Spektrum von Leistungsanforderungen, das heißt sowohl bei geringer als auch bei großer abzutransportierender Wärmemenge, demgegenüber insbesondere bezüglich der Energieeffizienz verbessert ist.

Die Aufgabe wird erfindungsgemäß durch ein Verfahren der eingangs genannten Art gelöst, umfassend die Merkmale des Anspruchs 1. Dem erfindungsgemäßen Verfahren liegt die Idee zugrunde, zur Kühlung der Komponente in Abhängigkeit eines Kühlparameters zwei verschiedene Kühlverfahren zu nutzen, wobei ein automatischer Wechsel des Kühlmodus in Abhängigkeit des Kühlparameters vorgesehen ist. Im ersten Kühlmodus wird zur Kühlung ein umgewälztes Kühlmittel genutzt. Dieser Kühlmodus entspricht dem eingangs erläuterten Modus, bei dem, insbesondere mit hoher Geschwindigkeit, flüssiges Kühlmittel durch ein Kühlvolumen gepumpt wird, dass die zu kühlende Komponente thermisch kontaktiert. In einem zweiten Kühlmodus wird hingegen ein Verfahren genutzt, in dem das Kühlmittel nicht durch eine Umwälzeinrichtung zirkuliert wird, sondern in dem die Kühlmittelzirkulation dadurch erfolgt, dass Kühlmittel in heißen Bereichen, also an der Komponente selbst oder einem thermisch starken mit der Komponente gekoppelten Bereich des Kühlvolumens, verdampft. Dabei wird vom Kühlmittel zum einen aufgrund der Temperaturänderung des Kühlmittels und zum anderen aufgrund der Verdampfung des Kühlmittels Energie aufgenommen. Aufgrund dieser Verdampfung entsteht im Bereich, in dem das Kühlmittel verdampft wird, ein Überdruck, womit Dampfblasen des Kühlmittels in das Volumen des Kühlmittels eindringen und dort die aufgenommene Wärme an das weitere Kühlmittel beziehungsweise die Wände des Kühlvolumens abgeben. Damit wird durch das Verdampfen des Kühlmittels im Kühlmittel selbst ein Wärmetransport durch Konvektion erreicht. Die durch die Komponente in das Kühlvolumen und damit das flüssige Kühlmittel eingebrachte Wärme wird damit sehr schnell im gesamten Kühlvolumen verteilt. Durch diese Verteilung der Wärme wird die effektive Oberfläche, die zum Wärmetausch mit der Umgebung zur Verfügung steht, auf die Oberfläche des gesamten Kühlvolumens vergrößert. Damit kann alleine durch Verdampfung und den damit einhergehenden Wärmetransport durch Konvektion im Kühlvolumen eine ausreichende Kühlung der Komponente in vielen Fällen sichergestellt werden.

Der Kühlparameter kann im einfachsten Fall ein durch einen an der Komponente oder im Bereich der Komponente angeordneten Temperatursensor erfasster Temperaturwert sein. In diesem Fall kann bei Erfassung kleiner Temperaturwerte die Komponente im zweiten Kühlmodus gekühlt werden, wodurch eine Kühlung der Komponente mit keinem oder minimalen Energieaufwand möglich ist. Werden höhere Temperaturwerte erfasst, so bedeutet dies, dass eine stärkere Kühlung der Komponente notwendig ist. In diesem Fall kann sie im ersten Kühlmodus gekühlt werden, in dem das Kühlmittel in einem Kühlkreislauf umgewälzt wird. Dabei durchströmt kaltes Kühlmittel das Kühlvolumen insbesondere turbulent, wodurch ein großer Wärmetransport von der Komponente in den Kühlkreislauf und dort insbesondere zu einem Wärmetauscher erreicht wird. Der Kühlmodus kann also automatisch in Abhängigkeit einer Komponententemperatur gewechselt werden.

Wie bereits erwähnt, weisen insbesondere Leistungsbausteine häufig eine geringe thermische Trägheit auf, weshalb an diesen Bausteinen sehr schnelle Temperaturänderungen auftreten können. Daher kann es im erfindungsgemäßen Verfahren auch vorteilhaft sein, zusätzlich zu den oder statt der Temperaturwerte weitere Parameter zu erfassen, die bei der Bestimmung des Kühlparameters berücksichtigt werden. So kann beispielsweise eine Motorsteuerung bereits zeitgleich oder kurz vor oder nach einer Anforderung einer hohen Leistung vom Motor einen Kühlparameter entsprechend anpassen, dass ein Wechsel in den zweiten Kühlmodus erfolgt.

Ein automatischer Wechsel zwischen den Kühlmodi ist also in Abhängigkeit verschiedenster Kühlparameter möglich. Dabei kann insbesondere ein sofortiger Wechsel des Kühlmodus erfolgen, sobald der Kühlparameter einen Grenzwert überschreitet oder unterschreitet, es ist aber auch möglich, dass der Wechsel erst zeitverzögert erfolgt und/oder dass der Kühlmodus erst dann gewechselt wird, wenn ein Grenzwert für ein vorgegebenes Zeitintervall über- bzw. unterschritten wird. Das Zeitintervall kann dabei insbesondere abhängig vom Grad der Über- bzw. Unterschreitung des Grenzwertes sein.

Dabei kann die Komponente eine elektrische Komponente sein, wobei als Kühlparameter ein momentaner elektrischer Betriebsparameter der Komponente oder einer Schaltung, die die Komponente umfasst, oder ein durch die Steuereinrichtung vorgegebener Sollwert für den Betriebsparameter erfasst wird. Der Betriebsparameter kann dabei insbesondere eine Ist-Leistung, ein Ist-Strom oder eine Ist-Spannung sein. Alternativ kann der Betriebsparameter eine Sollleistung, eine Sollstrom oder eine Sollspannung sein. Dadurch wird, wie vorangehend beschrieben, erreicht, dass die Kühlung nicht erst nachträglich angepasst wird, wenn aufgrund einer vorangehenden Änderung der elektrischen Belastung der Komponente die Temperatur der Komponente steigt oder sinkt, sondern es kann bereits bei oder sogar vor Vorliegen der Ursache, also der Änderung der Belastung der Komponente, die Kühlleistung angepasst werden.

Durch die Erfassung momentaner elektrischer Betriebsparameter und/oder von Sollwerten für diese Betriebsparameter kann insbesondere auch das Kühlverfahren weiter optimiert werden. Ist beispielsweise bekannt, dass bei einem momentanen die Komponente durchfließenden Leistungswert eine ausreichende Kühlung der Komponente für beispielsweise 5 Sekunden möglich ist, so kann bei Erfassung dieses Leistungswertes zunächst beispielsweise für 3 oder 4 Sekunden der zweite Kühlmodus beibehalten werden und erst, wenn der erfasste Leistungswert nach dieser Zeit nicht wieder gesunken ist, in den ersten Kühlmodus gewechselt werden. Durch ein derartiges verzögertes Wechseln zwischen den Kühlmodi kann zum einen der Energieverbrauch des Kühlsystems weiter gesenkt werden, wodurch mit dem erfindungsgemäßen Verfahren das Kraftfahrzeug effizienter wird, wodurch die Reichweite des Kraftfahrzeugs steigt. Zum anderen kann durch eine derartige Ausbildung des Verfahrens auch die Leistungsfähigkeit des Kraftfahrzeugs insgesamt gesteigert werden. Ist die elektrische Komponente beispielsweise Teil der Leistungselektronik eines Kraftfahrzeugs, so ist es möglich, dass beim Betrieb der wenigstens einen Umwälzrichtung im ersten Kühlmodus gemeinsam mit dem Betrieb eines elektrischen Antriebs das Bordnetz so stark belastet wird, dass die Betriebsspannung im Bordnetz sinkt. Daher wird durch den Betrieb der Umwälzeinrichtungen die für den elektronischen Antrieb zur Verfügung stehende Leistung reduziert. Wird nun, wie vorangehend beschrieben, ermöglicht, dass kurzzeitig hohe Leistungen abgegeben werden können, ohne in den ersten Kühlmodus zu wechseln, so ist in diesem Zeitintervall eine maximale Leistungsabgabe möglich, da die elektrische Leistung des Bordnetzes nicht zwischen der wenigstens einen Umwälzeinrichtung und dem elektronischen Antrieb aufgeteilt werden muss.

Alternativ oder ergänzend zur beschriebenen Erfassung eines Soll- oder Istwerts eines elektrischen Betriebsparameters kann auch die Temperatur der Komponente oder weiterer Teile des Kraftfahrzeugs oder der Betriebsmodus des Kraftfahrzeugs ausgewertet werden. Dabei kann beispielsweise aus einer Sollleistung und der Temperatur eine gewichtete Summe gebildet werden, wobei der Betriebsmodus des Kraftfahrzeugs Gewichtungsfaktoren vorgibt. Als Betriebsmodus des Kraftfahrzeugs kommen dabei insbesondere verschiedene Fahrzeugeinstellungen des Kraftfahrzeugs, wie ein Komfort- oder Sportmodus, ein eingelegter Gang oder ähnliches in Frage. Neben der Nutzung gewichteter Summen ist es jedoch auch möglich, einzelne Betriebsparameter separat auszuwerten und insbesondere mit Grenzwerten zu vergleichen, wobei die Vergleichsergebnisse logisch verknüpft werden können, um den Kühlparameter und damit den Kühlmodus zu bestimmen. Damit kann beispielsweise erreicht werden, dass der Kühlmodus, solange die gemessene Temperatur unterhalb eines Grenzwertes ist, durch eine vorgegebene Sollleistung bestimmt wird, bei Überschreiten eines vorgegebenen Temperaturgrenzwertes jedoch stets in den ersten Kühlmodus gewechselt wird.

Als Betriebsparameter kann dabei insbesondere die Stromstärke eines Stromflusses durch die Komponente oder einen vorgegebenen Teil der Schaltung oder eine Spannung, die an der Komponente oder zwischen zwei vorgegebenen Punkten der Schaltung abfällt, oder eine durch die Schaltung abgegebene oder aufgenommene elektrische Leistung erfasst werden. Dabei ist es möglich den Momentanwert der genannten Größen auszuwerten, es können jedoch auch Sollwerte erfasst werden oder die Betriebsparameter können vorverarbeitet werden, um eine Statistik über ein vorgegebenes Zeitintervall auszuwerten. Dabei können neben Gleichspannungen, Gleichströmen und Gleichstromleistungen auch Wechselspannungen, Wechselströme und Wechselstromleistungen gemessen werden. Bei Wechselspannungen oder Wechselströmen als Betriebsparameter können insbesondere Maximalspannungen beziehungsweise -ströme oder die RMS-Werte der Spannungen oder Ströme ausgewertet werden. Bei der Auswertung einer Wechselstromleistung kann die Wirk- und/oder Blindleistung erfasst und ausgewertet werden.

Eine dynamische Regelung des Kühlmodus kann insbesondere erreicht werden, wenn der Kühlparameter laufend erfasst wird und bei Überschreiten eines ersten vorgegebenen Grenzwertes durch den Kühlparameter und bei Unterschreiten des ersten oder eines zweiten vorgegebenen Grenzwertes durch die Steuereinrichtung der Kühlmodus gewechselt wird. Die laufende Erfassung des Kühlparameters kann dabei periodisch erfolgen, es ist jedoch auch möglich, die Erfassung kontinuierlich, insbesondere durch eine analoge Steuerungseinrichtung, durchzuführen. Der erste und/oder zweite Grenzwert kann dabei dynamisch angepasst werden. Insbesondere können der erste und/oder der zweite Grenzwert von einem Betriebsmodus des Kraftfahrzeugs abhängen.

Wird ein vom ersten Grenzwert unterschiedlicher zweiter Grenzwert genutzt, so ist das Umschalten zwischen dem ersten und dem zweiten Kühlmodus bezüglich des Kühlparameters hysteretisch. Dies ist vorteilhaft, da beim Umschalten zwischen den beiden Kühlmodi zum einen eine gewisse Mindestzeit erforderlich ist und zum anderen potentiell der Energieverbrauch des Kraftfahrzeugs kurzfristig erhöht wird. Durch ein hysteretisches Schalten zwischen den beiden Betriebsmodi wird ein ständiges Hin- und Herschalten im Grenzbereich vermieden.

Im zweiten Kühlmodus erfolgt eine Kühlung der Komponente durch Verdampfen von Kühlmittel. Wie bereits erläutert ist die Nutzung des erfindungsgemäßen Verfahrens insbesondere bei Nutzung von Leistungselektronikkomponenten vorteilhaft. Bei Leistungselektronikkomponenten handelt es sich häufig um Halbleiterbauteile, die beispielsweise bei Betriebstemperaturen von 70 °C oder 90 °C noch zuverlässig funktionieren, aber ab einer gewissen Temperatur, beispielsweise 100 °C, beschädigt werden können oder ihre Aufgabe in einer Schaltung nicht mehr zuverlässig erfüllen können. Als Kühlmittel in Kraftfahrzeugen wird häufig Wasser eingesetzt, das bei Normaldruck einen Siedepunkt von 100 °C aufweist. Häufig werden dem Wasser Zusätze beigesetzt, die korrosionshemmend wirken und/oder ein Einfrieren des Wassers bei tiefen Temperaturen verhindern. Hierzu können beispielsweise Wärmeträgerflüssigkeiten auf Basis von Monoethylenglykol genutzt werden. Derartige Flüssigkeiten haben für sich genommen einen Siedepunkt im Bereich von über 150 °C. Gemische aus Wasser und derartigen Wärmeleitflüssigkeiten weisen typischerweise Siedepunkte im Bereich von knapp oberhalb von 100 °C bei Normaldruck auf. Daher ist es bei einer Kühlung in der Komponente im zweiten Kühlmodus durch eine Kühlflüssigkeit bei Normaldruck notwendig, Leistungselektronikkomponenten zu nutzen, die bei hohen Temperaturen funktionsfähig sind oder andere Kühlmittel mit einem tieferen Siedepunkt zu nutzen.

Daher wird vorgeschlagen, dass beim Wechsel vom ersten in den zweiten Kühlmodus der Druck im Kühlvolumen reduziert wird. Durch dieses Vorgehen wird erreicht, dass das Umwälzen des Kühlmittels bei Normaldruck erfolgen kann, wodurch der Kühlkreislauf einschließlich des optionalen Wärmetauschers und der Umwälzeinrichtung nicht modifiziert werden muss. Eine Drucksenkung erfolgt ausschließlich im zweiten Kühlmodus, in dem das Kühlvolumen vom Kühlkreislauf abgetrennt ist. Dadurch muss ausschließlich im Kühlvolumen der Druck des Kühlmittels kontrolliert werden. Die Absenkung des Drucks kann dabei beispielsweise erfolgen, indem am Kühlvolumen gepumpt wird, um den Druck im Kühlvolumen zu reduzieren. Dazu kann beispielsweise zunächst das Kühlvolumen vom Kühlkreislauf getrennt werden und anschließend durch eine zusätzliche Pumpe Kühlmittel aus dem Kühlvolumen gepumpt werden. Da kein weiteres Kühlmittel in das Kühlvolumen nachfließen kann, sinkt dadurch der Druck im Kühlvolumen. Alternativ kann nach dem Abschließen des Kühlvolumens auch das Kühlvolumen selbst vergrößert werden, indem beispielsweise ein Kolben zurückgezogen wird, um das Volumen zu vergrößern oder Ähnliches.

Besonders vorteilhaft kann jedoch die ohnehin im Kühlkreislauf vorhandene Umwälzeinrichtung genutzt werden, um den Druck im Kühlvolumen zu senken. Dies ist beispielsweise möglich, indem in Strömungsrichtung des Kühlmittels im ersten Kühlmodus die erste Kopplungseinrichtung vor dem Kühlvolumen und die zweite Kopplungseinrichtung hinter dem Kühlvolumen angeordnet ist, wobei bei einem Wechsel vom ersten in den zweiten Kühlmodus zuerst die erste Kopplungseinrichtung getrennt wird, wonach erst nach einem vorgegebenen Zeitraum und/oder bei Erfüllen einer vorgegebenen Trennbedingung die zweite Kopplungseinrichtung getrennt wird. Durch das Trennen der ersten Kopplungseinrichtung wird das Kühlvolumen einseitig abgeschlossen und verhindert, dass durch die erste Kopplungseinrichtung weiteres Kühlmittel in das Kühlvolumen einfließt. Gleichzeitig wird, da der Ausfluss des Kühlvolumens weiterhin mit dem Kühlkreislauf verbunden ist, durch die Umwälzeinrichtung Kühlflüssigkeit aus dem Kühlvolumen gepumpt. Dadurch wird im Kühlvolumen ein Unterdruck erzeugt. Abhängig von der Spezifikation der Umwälzeinrichtung, die insbesondere eine Pumpe ist, insbesondere abhängig vom Druckunterschied, den die Umwälzeinrichtung erzeugen kann, können relativ starke Unterdrücke im Kühlvolumen erreicht werden. So ist es beispielsweise möglich, den Druck von 1 Bar auf 0,2 Bar oder weniger zu senken. Nach einer vorgegebenen Zeit oder nach Erreichen einer vorgegebenen Bedingung kann die zweite Kopplungseinrichtung getrennt werden, wodurch im Kühlvolumen ein abgeschlossenes Volumen gebildet wird, das mit einem Kühlmittel mit geringem Druck gefüllt ist.

Dabei kann die Trennbedingung das Unterschreiten eines vorgegebenen ersten Druckwertes im Kühlvolumen sein. Durch diese Trennbedingung wird sichergestellt, dass im Kühlvolumen ein Druck hergestellt wird, der bei oder unterhalb eines vorgegebenen Druckwertes liegt. Zugleich wird sichergestellt, dass die Siedetemperatur des Kühlmittels gleich oder kleiner einem dem vorgegebenen Druckwert zugeordneten Temperaturwert ist. Zur Erfassung des Drucks kann dabei im Kühlvolumen eine Druckmesseinrichtung vorgesehen sein. Alternativ können auch Druckwerte in anderen Teilen der Kühleinrichtung, beispielsweise in einem Ausgleichsbehälter des Kühlkreislaufes oder im Rohrsystem der Kühleinrichtung durch an den jeweiligen Stellen angeordnete Druckmesseinrichtungen erfasst und im Rahmen der Trennbedingung ausgewertet werden. Alternativ oder ergänzend ist es beispielsweise möglich die Leistungsaufnahme, eine Drehzahl oder einen anderen Parameter der Umwälzeinrichtung zu erfassen, der Rückschlüsse auf den Druckgradienten an der Umwälzeinrichtung erlaubt und diesen Parameter im Rahmen der Auswertung der Trennbedingung zu nutzen.

Um eine möglichst effektive Kühlung der Komponente sowie ein möglichst zügiges Umschalten von dem zweiten Kühlmodus in den ersten Kühlmodus zu ermöglichen, ist es vorteilhaft, wenn bereits durch die Wiederankopplung des Kühlvolumens an den Kühlkreislauf der Strömungsaufbau für die Kühlung durch Umwälzung des Kühlmittels unterstützt wird. Hierzu ist es möglich, dass in Strömungsrichtung des Kühlmittels im ersten Kühlmodus die erste Kopplungseinrichtung vor dem Kühlvolumen und die zweite Kopplungseinrichtung hinter dem Kühlvolumen angeordnet ist, wobei bei einem Wechsel von dem zweiten Kühlmodus in den ersten Kühlmodus zuerst die erste Kopplungseinrichtung verbunden wird, wonach erst nach einem vorgegebenen Zeitraum und/oder bei Erfüllen einer vorgegebenen Verbindebedingung die zweite Kopplungseinrichtung verbunden wird. Dies ist insbesondere vorteilhaft, wenn im zweiten Kühlmodus der Druck im Kühlvolumen unterhalb des Drucks im weiteren Kühlkreislauf liegt. In diesem Fall beginnt bereits bei Verbinden der ersten Kopplungseinrichtung Kühlmittel in das Kühlvolumen einzuströmen, um den Druckunterschied zwischen dem Kühlvolumen und dem weiteren Kühlkreislauf auszugleichen. Dadurch wird bereits eine Strömung aufgebaut, die in Richtung der im ersten Kühlmodus zur Kühlung genutzten Strömung fließt. Nach einem vorgegebenen Zeitraum oder bei Erfüllen einer vorgegebenen Verbindebedingung wird dann davon ausgegangen, dass der Druckunterschied im Wesentlichen ausgeglichen ist. Daraufhin wird die zweite Kopplungseinrichtung verbunden. Aufgrund der Trägheit des Flüssigkeitsstroms fließt nun weiter Kühlmittel durch die erste Kopplungseinrichtung in das Kühlvolumen und strömt aus dem Kühlvolumen über die zweite Kopplungseinrichtung wieder in den Kühlkreislauf. Anschließend kann die Umwälzeinrichtung aktiviert werden, wobei das Anlaufen der Umwälzeinrichtung besonders energieeffizient erfolgen kann, da bereits eine Anfangsbewegung der Kühlflüssigkeit in Strömungsrichtung vorgegeben ist. Abhängig vom konkreten Aufbau des Kühlkreislaufes kann es auch vorteilhaft sein, die Umwälzeinrichtung gleichzeitig mit dem Verbinden der zweiten Kopplungseinrichtung oder zwischen dem Verbinden der ersten Kopplungseinrichtung und dem Verbinden der zweiten Kopplungseinrichtung zu aktivieren.

Die Verbindungsbedingungen kann insbesondere das Überschreiten eines vorgegebenen zweiten Druckwerts im Kühlvolumen sein. Dabei wird der Druck im Kühlvolumen wie oben beschrieben durch eine Druckmesseinrichtung, insbesondere einen Drucksensor im Kühlvolumen, erfasst. Der Druck kann jedoch auch an anderen Stellen des Kühlkreislaufes erfasst werden oder es können beispielsweise Betriebsparameter einer Umwälzeinrichtung, beispielsweise eine Drehzahl, ausgewertet werden. Dabei kann bereits vor Aktivieren der Umwälzeinrichtung eine Drehzahl erfasst werden, da die sich aufbauende Strömung die unangetriebene Umwälzeinrichtung bewegen kann.

Wie erläutert erfolgt im zweiten Kühlmodus die Kühlung der Komponente dadurch, dass Kühlmittel verdampft wird. Dabei ist ein Verdampfen des Kühlmittels bei den meisten Kühlmitteln mit einer deutlichen Volumenausdehnung des verdampften Kühlmittels verbunden. Ohne Gegenmaßnahmen führt diese Volumenausdehnung des verdampften Kühlmittels dazu, dass das weitere Kühlmittel komprimiert wird, wodurch der Druck im Kühlvolumen ansteigt. Durch diesen Druckanstieg wird wiederum die Siedetemperatur des Kühlmittels erhöht. Wie oben beschrieben wird es damit notwendig, insgesamt ein tiefen siedendes Kühlmittel zu nutzen oder eine Komponente zu nutzen, die eine höhere Temperaturbeständigkeit aufweist. Dabei ist jedoch zu beachten, dass bei einem ausreichend großen Kühlvolumen nur ein sehr kleiner Teil des gesamten Kühlmittels des Kühlvolumens verdampft, so dass der Volumenanstieg und damit der Druckanstieg relativ gering ist.

Um einen solchen Druckanstieg jedoch weiter zu reduzieren beziehungsweise weitestgehend zu verhindern, ist es jedoch möglich, dass eine mit dem Kühlvolumen verbundene Volumenausgleichseinrichtung genutzt wird, die eine Ausdehnung und/oder eine Reduzierung des Kühlvolumens gegen eine vorgegebene Kraft ermöglicht. Dabei ist das Verbundensein in diesem Zusammenhang so zu verstehen, dass ein freier Austausch von Kühlflüssigkeit zwischen dem Kühlvolumen und der Volumenausgleichseinrichtung möglich ist, wobei diese, insbesondere durch Rohre oder Ähnliches, verbunden sein können oder wobei die Volumenausgleichseinrichtung direkt an einer Wand des Kühlvolumens angeordnet ist. Dabei kann die Volumenausgleichseinrichtung gebildet sein, indem ein Kolben vorgesehen ist, der durch das Kühlmittel gegen eine vorgegebene Kraft bewegt werden kann, um das Kühlvolumen zu vergrößern. Dabei kann der Kolben insbesondere durch eine Feder oder ein anderes elastisches Element gelagert sein. Es ist jedoch auch möglich Gegengewichte oder ähnliches zu nutzen, um stellungsunabhängig eine konstante Kraft auf den Kolben auszuüben. Alternativ kann die Volumenausgleichseinrichtung auch ausgebildet sein, indem zumindest ein Abschnitt des Kühlvolumens aus einem elastischen, insbesondere einem gummielastischen, Material gebildet ist.

Im ersten Kühlmodus soll ein möglichst rascher Wärmeabtransport von der Komponente ermöglicht werden. Daher ist es vorteilhaft, wenn möglichst große Teile des durch das Kühlvolumen geleiteten Kühlmittels in direkten Kontakt mit der Komponente selbst oder einem stark thermischen mit der Komponente gekoppelten Bereich des Kühlvolumens treten. Dies kann insbesondere dadurch erreicht werden, dass im ersten Kühlmodus das Kühlmittel turbulent durch das Kühlvolumen geleitet wird. In diesem Fall ist das Kühlmittel verwirbelt, so dass ein steter Austausch von Kühlmittel zwischen einem Randbereich, der mit der Komponente beziehungsweise dem gut thermisch gekoppelten Bereich der Wand in Kontakt ist, und dem Rest des Volumenstroms erfolgen kann.

Des Weiteren betrifft die Erfindung eine Kühleinrichtung zur Kühlung einer Komponente eines Kraftfahrzeugs, die thermisch mit einem mit einem Kühlmittel gefüllten Kühlvolumen der Kühleinrichtung gekoppelt ist, wobei die Kühleinrichtung zur Durchführung einer der beschriebenen Ausführungsformen des erfindungsgemäßen Verfahrens ausgebildet ist. Dabei können die erste und die zweite Kopplungseinrichtung der Kühleinrichtung Ventile sein, die insbesondere durch die Steuereinrichtung gesteuert werden. Die Umwälzeinrichtung kann als Pumpe ausgebildet sein. Dabei kann die Steuereinrichtung insbesondere ausgebildet sein, im zweiten Kühlmodus die Umwälzeinrichtung zu deaktivieren. Insbesondere kann eine Bestromung einer Pumpe unterbrochen werden. Wie erläutert kann es zudem vorgesehen sein, dass eine Volumenausgleichseinrichtung im oder am Kühlvolumen angeordnet ist.

Wie mit Bezug auf das Verfahren erläutert ist es dabei möglich, dass die Umwälzeinrichtung genutzt wird, um einen Unterdruck im Kühlvolumen zu erzeugen. Werden in der Kühleinrichtung keine weiteren Vorkehrungen getroffen, so führt dieses Pumpen dazu, dass in einem anderen Teil des Kühlkreislaufes der Druck durch das zusätzliche in diesem Bereich gepumpte Kühlmittel erhöht wird. Dabei weisen flüssige Kühlmittel, insbesondere Wasser, häufig eine geringe Kompressibilität auf, das heißt, dass bereits das Einpumpen einer relativ kleinen Menge von Kühlmittel in ein festes Volumen zu einer relativ starken Druckänderung führt. Um zu verhindern, dass dadurch die Druckreduzierung im Kühlvolumen begrenzt wird, kann im Kühlkreislauf ein Ausgleichsbehälter für das Kühlmittel vorgesehen sein.

Ein solcher Ausgleichsbehälter kann durch ein Volumen gebildet werden, das teilweise mit Kühlmittel und teilweise mit einem Gas, insbesondere Luft, gefüllt ist. Dabei ist es möglich, dass der Ausgleichsbehälter derart ausgebildet ist, dass an zumindest einem Teil seiner Oberfläche Gas aus dem Ausgleichsbehälter austreten und in diesen eintreten kann, wobei insbesondere an der gleichen Stelle Kühlmittel weder in den Ausgleichsbehälter ein- noch aus ihm austreten kann. Wird nun zusätzliches Kühlmittel in den Ausgleichsbehälter gepumpt, so wird Gas aus dem Ausgleichsbehälter herausgedrückt. Wird Kühlmittel dem Ausgleichsbehälter entnommen, so wird das freiwerdende Volumen durch eintretendes Gas befüllt. Alternativ wäre es auch möglich, einen gasdichten Ausgleichsbehälter zu nutzen. Dies ist insbesondere möglich, weil Gase typischerweise eine wesentlich höhere Kompressibilität aufweisen als Flüssigkeiten. Bei einem Anstieg des Drucks würde in diesem Fall vor allem das Gas zusammengedrückt. Alternativ zu einem Ausgleichsbehälter könnte zum Druckausgleich auch ein Kolben oder eine elastische Wand genutzt werden, wie bereits mit Bezug zur Volumenausgleichseinrichtung beschrieben.

Im Kühlvolumen und/oder im Kühlkreislauf kann wenigstens eine Druckmesseinrichtung zur Erfassung des Kühlmitteldrucks angeordnet sein. Die Druckmesseinrichtung kann die Druckmesswerte an die Steuereinrichtung bereitstellen. Die Messwerte der Druckmesseinrichtung können dabei insbesondere bei der Auswertung der Kopplungsbedingung und/oder der Trennbedingung berücksichtigt werden.

Zudem betrifft die Erfindung ein Kraftfahrzeug, umfassend wenigstens eine zu kühlende Komponente, wobei das Kraftfahrzeug eine erfindungsgemäße Kühleinrichtung gemäß einer der oben beschriebenen Ausführungsformen umfasst, wobei die Komponente thermisch mit einem mit einem flüssigen Kühlmittel gefüllten Kühlvolumen der Kühleinrichtung gekoppelt ist.

Dabei kann die Komponente insbesondere eine Leistungselektronikkomponente eines elektrischen Antriebs des Kraftfahrzeugs sein. Wie oben beschrieben sind insbesondere Leistungselektronikkomponenten des Antriebs Komponenten, die abhängig von dem Fahrzustand des Kraftfahrzeugs stark unterschiedlich belastet werden können. Daher ist es insbesondere für diese Komponente vorteilhaft, unterschiedliche Kühlmodi vorzusehen.

Die Steuereinrichtung des erfindungsgemäßen Kraftfahrzeugs kann zur Begrenzung der Leistung des Antriebs bei Kühlung im zweiten Kühlmodus auf einen Maximalleistungswert, der kleiner ist als ein Leistungswert, mit dem der Antrieb im ersten Kühlmodus betreibbar ist, ausgebildet sein. Entsprechend ist es auch möglich, dass ein Strom und/oder eine Spannung begrenzt wird. Eine derartige Leistungsbegrenzung kann insbesondere gewünscht sein, wenn ein besonders energieeffizienter Betrieb des Kraftfahrzeugs gewünscht ist. Wie eingangs erläutert, kann insbesondere bei leistungsstarken Kraftfahrzeugen der Betrieb einer Kühleinrichtung einen wesentlichen Beitrag zum Energieverbrauch des Kraftfahrzeugs leisten. Bei einem Fahren in einer ruhigen Verkehrssituation und/oder im Stadtverkehr ist es aber möglich, dass diese Leistungsreserven nicht zur Verfügung gestellt werden sollen, um ein effizienteres Fahren zu ermöglichen. Insbesondere ist eine solche Begrenzung der Leistung des Antriebs jedoch auch vorteilhaft, um einen Abruf von mehr Leistung erst dann zu ermöglichen, wenn die Umschaltung vom zweiten in den ersten Kühlmodus vollständig erfolgt ist. So ist es beispielsweise möglich, dass die Umwälzeinrichtungen der Kühleinrichtung ein gewisses Zeitintervall zum Anlaufen benötigen. Um ein starkes Erhitzen der Komponente zu verhindern, kann die Leistung in diesem Fall zunächst weiter auf einen Maximalleistungswert begrenzt werden.

Dabei ist es möglich, dass die Steuereinrichtung ausgebildet ist, eine Sollleistung zu erfassen, die durch eine Fahrzeugeinrichtung, insbesondere ein fahrerseitig bedienbares Bedienelement oder ein Fahrerassistenzsystem, vorgebbar ist, und bei Erfassung einer Sollleistung, die größer ist als der Maximalleistungswert, in den ersten Kühlmodus zu schalten. Somit kann insbesondere die Leistung während eines Betriebsmodus auf den Maximalleistungswert begrenzt werden und in dem Fall, in dem ein Fahrer oder ein Fahrerassistenzsystem eine höhere Leistung anfordert als den Maximalleistungswert, kann zunächst in den ersten Kühlmodus umgeschaltet werden und nach Umschalten in den ersten Kühlmodus kann die gewünschte Leistung zur Verfügung gestellt werden.

Insbesondere in leistungsstarken Kraftfahrzeugen ist häufig eine Möglichkeit vorgesehen, dass ein Benutzer einen gewünschten Betriebsmodus, beispielsweise Komfort, Sport, Offroad oder Ähnliches, vorgeben kann, wobei bei Umstellung des Fahrzeugmodus zahlreiche Fahrzeugparameter angepasst werden. Daher kann das erfindungsgemäße Kraftfahrzeug eine Eingabeeinrichtung zur Erfassung einer Benutzereingabe zur Wahl eines Fahrzeugmodus und eine Steuereinrichtung umfassen, wobei die Steuereinrichtung zur Bestimmung des Kühlparameters und/oder des ersten und/oder des zweiten Grenzwertes für den Kühlparameter und/oder des Maximalleistungswertes in Abhängigkeit des Fahrzeugmodus dient. So ist es beispielsweise möglich, dass im Kraftfahrzeug ein besonders sparsamer Fahrzeugmodus vorgesehen ist, in dem die Kühlung grundsätzlich im zweiten Kühlmodus erfolgt, wobei die Leistung auf einen Maximalleistungswert begrenzt wird, um eine Beschädigung der Komponente durch Überhitzen zu verhindern. Andererseits kann ein besonders sportlicher Fahrzeugmodus vorgesehen sein, in dem eine Kühlung stets im ersten Kühlmodus erfolgt, so dass verzögerungsfrei stets die volle Leistung des Kraftfahrzeugs zur Verfügung steht. Es ist auch möglich, dass in einem weiteren sportlichen Fahrzeugmodus der erste und zweite Grenzwert für den Kühlparameter derart gewählt werden, dass nur bei sehr geringen Belastungen der Komponente in den zweiten Kühlmodus geschaltet wird, wobei bereits frühzeitig bei einer Belastung der Komponente, die an sich noch keine Kühlung im ersten Kühlmodus notwendig machen würde, in den ersten Kühlmodus geschaltet wird, um ohne Verzögerung höhere Leistungen zur Verfügung stellen zu können. Die genannten Fahrzeugmodi sind rein beispielhaft und für den Fachmann ergeben sich eine Vielzahl weiterer möglicher Fahrzeugmodi.

Im Kraftfahrzeug können selbstverständlich mehrere Komponenten gekühlt werden, wobei es dabei möglich ist, einzelne oder einige dieser Komponenten jeweils in einem separaten Kühlvolumen anzuordnen. Dabei können erste Komponenten in einem ersten Kühlvolumen und zweite Komponenten in einem zweiten Kühlvolumen liegen, wobei jedes dieser Kühlvolumen erste und zweite Kopplungseinrichtungen aufweist und jedes dieser Kühlvolumen getrennt von einem gemeinsamen Kühlkreislauf entkoppelt werden kann. Eine Kühlung des ersten Kühlvolumens im ersten Kühlmodus und des zweiten Kühlvolumens im zweiten Kühlmodus oder umgekehrt ist dabei möglich, wenn für die Kühlvolumen jeweils ein Bypass vorgesehen ist oder wenn die Kühlvolumen parallel durchströmt werden.

Weitere Vorteile und Einzelheiten der Erfindung ergeben sich aus den nachfolgenden Ausführungsbeispielen sowie den zugehörigen Zeichnungen. Dabei zeigen:
- Fig. 1: schematisch eine erfindungsgemäße Kühleinrichtung,
- Fig. 2: schematisch ein erfindungsgemäßes Kraftfahrzeug, und
- Fig. 3: schematisch ein Ablaufdiagramm eines erfindungsgemäßen Verfahrens.

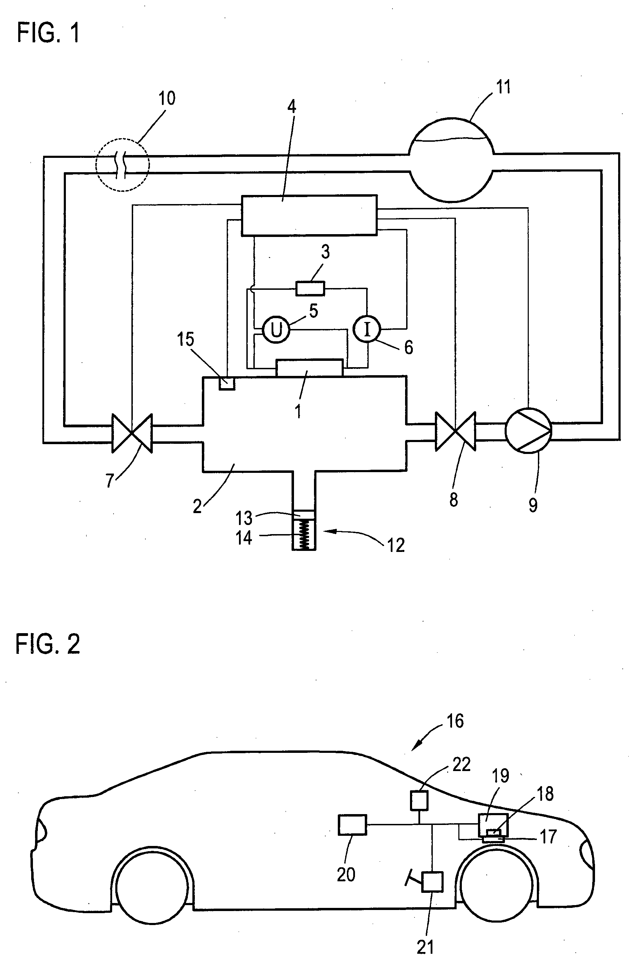

Fig. 1 zeigt schematisch eine Kühleinrichtung zur Kühlung einer Komponente 1 eines Kraftfahrzeugs, die thermisch mit einem mit flüssigem Kühlmittel gefüllten Kühlvolumen 2 gekoppelt ist. Die Komponente 1 ist ein Spannungswandler, der mit weiteren Komponenten 3 ein elektrisches Antriebssystem des Kraftfahrzeugs ausbildet. Dabei umfasst die Kühleinrichtung eine Steuereinrichtung 4 zur Steuerung der Kopplungseinrichtungen 7, 8 und der Umwälzeinrichtung 9. In Abhängigkeit einer die Komponente 1 durchfließenden Leistung wird die Komponente 1 bei hohen Leistungen in einem ersten Kühlmodus gekühlt, in dem das Kühlvolumen 2 über eine erste Kopplungseinrichtung 7 und eine zweite Kopplungseinrichtung 8, die beide als Ventile ausgebildet sind, mit einem Kühlkreislauf verbunden ist, der wenigstens eine Umwälzeinrichtung 9 umfasst, durch die das Kühlmittel umgewälzt wird. Bei geringer Leistung wird die Komponente 1 in einem zweiten Kühlmodus gekühlt, in dem das Kühlvolumen 2 durch die erste Kopplungseinrichtung 7 und die zweite Kopplungseinrichtung 8 vom Kühlkreislauf getrennt ist. Hierzu sind die Ventile, die die erste und zweite Kopplungseinrichtung 7, 8 ausbilden, durch die Steuereinrichtung 4 steuerbar.

Zur Ermittlung der die Komponente 1 durchfließenden Leistung umfasst die Kühl-einrichtung ein Spannungsmessgerät 5, das parallel zur Komponente 1 geschaltet ist, und ein Strommessgerät 6, das in Serie zur Komponente 1 geschaltet ist. Das Spannungsmessgerät 5 und das Strommessgerät 6 werden durch die Steuereinrichtung 4 ausgelesen und in der Steuereinrichtung 4 wird durch Multiplikation der Messwerte eine Leistung berechnet, die die Komponente 1 durchfließt. Zudem ist an der Komponente 1 ein nicht gezeigter Temperatursensor angeordnet, der ebenfalls durch die Steuereinrichtung 4 ausgelesen wird. Die Steuereinrichtung 4 ist dabei ausgebildet, die Ventile, die die erste und zweite Kopplungseinrichtung 7, 8 ausbilden, sowie die Umwälzeinrichtung 9 zu steuern, um vom ersten Kühlmodus in den zweiten Kühlmodus oder umgekehrt zu wechseln. Die Steuereinrichtung ist ausgebildet, einen Wechsel in den ersten Kühlmodus einzuleiten, wenn der Temperaturmesswert des nicht gezeigten Temperatursensors einen vorgegebenen Temperaturgrenzwert überschreitet, oder die durch die Komponente 1 fließende Leistung einen ersten Grenzwert überschreitet. Die Temperaturmessung dient hierbei als Rückfallebene, die sicherstellt, dass beim Überschreiten eines vorgegebenen Temperaturgrenzwerts stets in den ersten Betriebsmodus gewechselt wird. Ist der Temperaturgrenzwert durch den Temperaturmesswert unterschritten und ist die durch die Komponente 1 transportierte Leistung geringer als ein zweiter Grenzwert, so ist die Steuereinrichtung 4 ausgebildet, in den zweiten Kühlmodus zu wechseln.

Zunächst befindet sich die Kühleinrichtung im ersten Kühlmodus, das heißt, Kühlflüssigkeit kann durch die erste Kopplungseinrichtung 7 in das Kühlvolumen 2 eintreten und durch die zweite Kopplungseinrichtung 8 aus dem Kühlvolumen austreten. Das Kühlmittel wird dabei durch die Umwälzeinrichtung 9 umgewälzt. Im weiteren Kühlkreislauf sind zusätzlich Komponenten 10, insbesondere ein Wärmetauscher, sowie ein Ausgleichsbehälter 11 angeordnet. Der Ausgleichsbehälter 11 ist durch ein Volumen ausgebildet, das nur teilweise mit Kühlflüssigkeit gefüllt ist. Der Ausgleichsbehälter 11 ist zudem derart ausgebildet, dass ein Gasaustausch mit der Umgebung möglich ist, also Gas aus dem Ausgleichsbehälter entweichen und in diesen eintreten kann, jedoch keine Kühlflüssigkeit.

Zum Wechsel in den zweiten Kühlmodus wird zunächst die Kopplungseinrichtung 7 angesteuert, um das Kühlvolumen 2 auf der Einflussseite vom Kühlkreislauf zu trennen. Da die Umwälzeinrichtung 9 währenddessen weiter betrieben wird, wird Kühlmittel aus dem Kühlvolumen 2 transportiert und es kann kein weiteres Kühlmittel nachfließen. Dadurch wird ein Unterdruck erzeugt. Durch den entstehenden Unterdruck wird gleichzeitig das Kühlvolumen durch die Volumenausgleichseinrichtung 12 verkleinert. Die Volumenausgleichseinrichtung 12 ist als Zylinder mit einer verschiebbaren Platte 13 ausgebildet, die gegenüber dem Kühlmittel abgedichtet ist und die durch eine Feder 14 gelagert ist. Bei einem Absinken des Drucks im Kühlvolumen 2 wird die Platte 13 in Richtung des Kühlvolumens gezogen. Da die durch die Feder 14 ausgeübte Kraft proportional zur Auslenkung der Platte 13 ist und die aufgrund des Unterdrucks im Kühlvolumen 2 auf die Platte 13 wirkende Kraft zum Druckunterschied zwischen dem Kühlvolumen 2 und der Umgebung proportional ist, ist auch die Auslenkung der Platte 13 zum Unterdruck zwischen Kühlvolumen 2 und Umgebung proportional.

Das dem Kühlvolumen 2 entnommene Kühlmittel wird dabei in den Ausgleichsbehälter 11 geleitet. Während des Abpumpens des Kühlmittels aus dem Kühlvolumen 2 zur Senkung des Drucks im Kühlvolumen 2 wird der Druck im Kühlvolumen 2 laufend durch den im Kühlvolumen 2 angeordneten Druckmesssensor 15 erfasst. Die Druckmesswerte des Druckmesssensors 15 werden durch die Steuereinrichtung 4 mit einem ersten Druckgrenzwert verglichen. Unterschreiten die Druckmesswerte den ersten Druckgrenzwert, so steuert die Steuereinrichtung 4 die Kopplungseinrichtung 8 an, um das Kühlvolumen 2 ausflussseitig vom Kühlkreislauf zu entkoppeln. Damit ist das Kühlvolumen 2 nun vollständig vom Kühlkreislauf entkoppelt. Anschließend kann die Umwälzeinrichtung 9 durch die Steuereinrichtung 4 deaktiviert werden. Dadurch wird im zweiten Kühlmodus keine Energie durch die Umwälzeinrichtung 9 verbraucht.

Die Kühlung der Komponente 1 im zweiten Kühlmodus erfolgt durch Verdampfung des Kühlmittels im an die Komponente 1 angrenzenden Bereich des Kühlvolumens 2. Dadurch werden Gasblasen gebildet, die Kühlmittel im Kühlvolumen 2 verdrängen und damit den Druck im Kühlvolumen 2 temporär erhöhen. Diese Druckerhöhung kann jedoch durch die Volumenausgleichseinrichtung 12 ausgeglichen werden. Durch die Verdampfung von flüssigem Kühlmittel in dem der Komponente 1 benachbarten Bereiche des Kühlvolumens 2 entsteht ein Überdruck in diesem Bereich und das erwärmte bzw. verdampfte Kühlmittel wird aus diesem Bereich verdrängt. Gleichzeitig fließt kühles Kühlmittel in diesem Bereich nach. Dadurch entsteht innerhalb des Kühlvolumens 2 eine Konvektionsbewegung des Kühlmittels, die die Komponente 1 kühlt. Aufgrund dieser Kühlmittelkonvektion erfolgt eine sehr gute Wärmeleitung innerhalb des Kühlvolumens 2. Die Oberfläche der Komponente 1, über die Wärme abgegeben werden kann, wird damit im Ergebnis auf die Gesamtoberfläche des Kühlvolumens 2 vergrößert.

Wird nun durch die Steuereinrichtung 4 ermittelt, dass ein Wechsel in den ersten Kühlmodus erfolgen soll, so steuert die Steuereinrichtung 4 zunächst die Kopplungseinrichtung 7 an, um das Kühlvolumen 2 einflussseitig mit dem Kühlkreislauf zu koppeln. Da im Kühlkreislauf ein höherer Druck als im Kühlvolumen 2 herrscht, strömt Kühlmittel vom Kühlkreislauf in das Kühlvolumen 2. Damit sinkt der Kühlmittelspiegel im Ausgleichsbehälter 11, die Volumenausgleichseinrichtung 12 bewegt sich in Richtung ihrer ursprünglichen Stellung und der Druck im Kühlvolumen 2 steigt. Während dieses-Druckanstiegs werden durch die Druckmesseinrichtung 15 laufend Druckwerte erfasst. Übersteigen die erfassten Druckwerte einen zweiten in der Steuereinrichtung 4 vorgegebenen Druckgrenzwert, so steuert die Steuereinrichtung 4 die Kopplungseinrichtung 8 zur ausflussseitigen Kopplung des Kühlvolumens 2 mit dem Kühlkreislauf an. Da durch die vorhandene einflussseitige Kopplung des Kühlvolumens 2 mit dem Kühlkreislauf bereits eine Strömung in Gang gesetzt wurde, strömt diese Strömung nun weiter vom Kühlvolumen 2 durch die Kopplungseinrichtung 8 in Richtung der Umwälzeinrichtung 9. Dadurch wird an der Umwälzeinrichtung 9 bereits ein Kühlmittelfluss erreicht. Damit kann nun durch die Steuereinrichtung 4 die Umwälzeinrichtung 9 gestartet werden und es ist eine geringere Zeit und Energie zum Starten der Umwälzeinrichtung 9 notwendig, da bereits eine Kühlmittelströmung vorliegt.

Fig. 2 zeigt schematisch ein Kraftfahrzeug 16 mit einer Kühleinrichtung 17 zur Kühlung einer Komponente 18 des Kraftfahrzeugs 16. Die Komponente 18 ist Teil der Leistungselektronik des Antriebs 19 des Kraftfahrzeugs. Der Aufbau der Kühleinrichtung 17 entspricht dabei im Wesentlichen dem Aufbau der Kühleinrichtung, die in Fig. 1 gezeigt ist, wobei keine Messung der Leistung, die die Komponente 18 durchfließt, vorgesehen ist.

Zur Steuerung des Antriebs 19 sowie der Kühleinrichtung 17 und weiter nicht gezeigt Komponenten des Kraftfahrzeugs 16 umfasst das Kraftfahrzeug 16 eine Steuereinrichtung 20. Die Steuereinrichtung ist über einen Bus, beispielsweise einen CAN-Bus, mit den Komponenten des Antriebs 19, der Kühleinrichtung 17 sowie einem fahrerseitig bedienbaren Bedienelement 21 und einer Eingabeeinrichtung 22 verbunden. Das Bedienelement 21 ist im Kraftfahrzeug 16 als ein Gaspedal ausgebildet. Zur Steuerung der Fahrleistung werden die Stellung des Bedienelements 21 sowie weitere Fahrzeugdaten von nicht gezeigten Sensoren und Daten des Antriebs 19 von der Steuereinrichtung 20 erfasst und in Abhängigkeit dieser Daten wird der Antrieb 19 gesteuert. Damit wird im Kraftfahrzeug 16 zumindest bezüglich der Motorsteuerung ein Drive-by-wire-System ausgebildet, wobei sich die gezeigten Prinzipien selbstverständlich auch auf herkömmliche Motorsteuerungen übertragen lassen. Die Ansteuerung des Antriebs 19 sowie der Kühleinrichtung 17 für die Komponente 18 erfolgt zudem in Abhängigkeit von Benutzereingaben an der Eingabeeinrichtung 22. An der Eingabeeinrichtung 22 können verschiedene Fahrzeugmodi angewählt werden, die beispielsweise ein besonders sportliches, ein besonders energieeffizientes oder ein besonders komfortables Fahren ermöglichen.

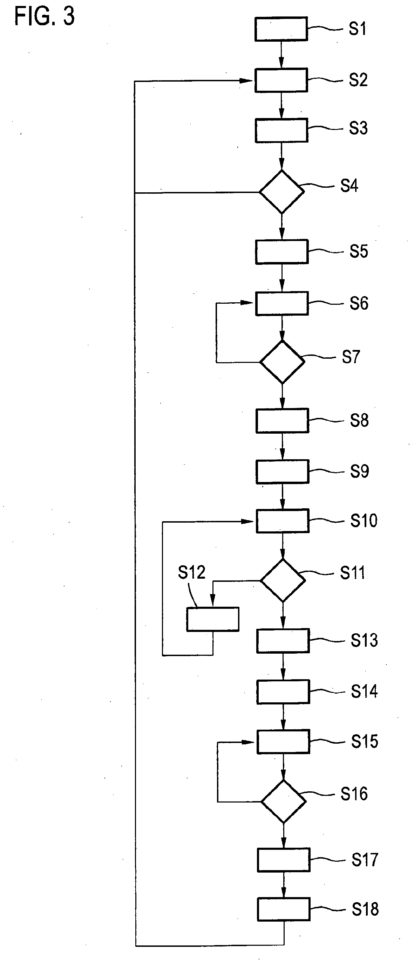

Die Steuereinrichtung 20 ist dabei ausgebildet, den Antrieb 19 sowie die Kühleinrichtung 17 in Abhängigkeit einer Sollleistung anzusteuern, die in Abhängigkeit der erfassten Stellung des Bedienelements 21 und unter Umständen des Fahrmodus bestimmt wird. Die Steuerung der Kühleinrichtung und des Motors erfolgt dabei wie im Folgenden mit Bezug auf Fig. 3 erläutert.

Fig. 3 zeigt schematisch ein Ablaufdiagramm eines Verfahrens zur Kühlung einer Komponente eines Kraftfahrzeugs, die thermisch mit einem mit einem flüssigen Kühlmittel gefüllten Kühlvolumen gekoppelt ist. In Schritt S1 wird zunächst eine Benutzereingabe an einer Eingabeeinrichtung des Kraftfahrzeugs erfasst, die einen Fahrzeugmodus wählt. Schritt S1 ist dabei optional, wobei bei einer nichtgetätigten Wahl des Fahrzeugmodus das Fahrzeug in einem zuvor gewählten Modus verbleibt. Alternativ könnte ein Standardfahrzeugmodus für das Kraftfahrzeug vorgesehen sein. In Abhängigkeit des Fahrzeugmodus werden mehrere im Verfahren genutzte Parameter angepasst, insbesondere der erste und zweite Grenzwert für den Kühlparameter sowie der Maximalleistungswert. Ergänzend wäre eine Abhängigkeit des Kühlparameters vom Fahrmodus möglich. Schritt S1 wird dabei während des Verlaufs des Verfahrens parallel zu den weiteren Verfahrensschritten wiederholt durchgeführt und bei Erfassung einer Benutzereingabe, die einen anderen als den bisherigen Fahrzeugmodus wählt, werden die entsprechenden Parameter entweder sofort oder zu vergebenen Punkten im Verfahren angepasst. Zur übersichtlichen Darstellung des Verfahrens ist die Erfassung einer Benutzerangabe in Schritt S1 ausschließlich zu Beginn des Verfahrens dargestellt.

In Schritt S2 wird durch eine Steuereinrichtung des Kraftfahrzeugs eine Solleistung für das Kraftfahrzeug bestimmt. Im in Fig. 2 gezeigten Kraftfahrzeug wird hierzu die Stellung des Bedienelements 21, also des Gaspedals, ausgewertet. Abhängig vom Kraftfahrzeug, in dem das Verfahren durchgeführt wird und vom Betriebszustand des Kraftfahrzeugs kann die Sollleistung dabei von einer Vielzahl weiterer Parameter abhängen bzw. durch ein Fahrerassistenzsystem vorgegeben sein.

Im dargestellten Verfahren erfolgt die Kühlung der Komponente zunächst im ersten Kühlmodus, in dem das Kühlvolumen über eine erste und zweite Kopplungseinrichtung mit einem Kühlkreislauf verbunden ist, der wenigstens eine Umwälzeinrichtung umfasst, durch die das Kühlmittel umgewälzt wird. Im ersten Kühlmodus wird eine starke Kühlung der Komponente erreicht, weshalb die zur Verfügung stehende Leistung nicht begrenzt ist. Daher kann in Schritt S3 nach Erfassung der Sollleistung in Schritt S2 direkt eine Ansteuerung des Motors derart erfolgen, dass dieser die angeforderte Sollleistung erzeugt.

In Schritt S4 wird anschließend überprüft, ob die in Schritt S2 erfasste Sollleistung kleiner ist als ein zweiter Grenzwert. Der zweite Grenzwert ist dabei ein Grenzwert für die Leistung, unterhalb dessen für den momentanen in Schritt S1 gewählten Fahrzeugmodus ein Wechsel in den zweiten Betriebsmodus vorgesehen ist. Der zweite Grenzwert ist dabei so gewählt, dass bei einem Betrieb des Antriebs mit einer Sollleistung, die gleich dem zweiten Grenzwert ist, im zweiten Kühlmodus eine ausreichende Kühlung für die Komponente sichergestellt ist. Je tiefer der zweite Grenzwert gewählt wird, desto seltener erfolgt ein Wechsel in den zweiten Kühlmodus. Ein seltener Wechsel in den zweiten Kühlmodus kann vorteilhaft sein, um ein häufiges Wechseln zwischen den Kühlmodi zu verhindern. Gleichzeitig kann ein relativ hoher zweiter Grenzwert insgesamt zu einer Energieersparnis im Kraftfahrzeug führen. Daher ist der zweite Grenzwert in Abhängigkeit des Fahrzeugmodus anpassbar. Ist die Sollleistung nicht kleiner als der zweite Grenzwert, so erfolgt die Kühlung weiterhin im ersten Kühlmodus und das Verfahren wird ab Schritt S2 wiederholt.

Ist die Sollleistung jedoch kleiner als der zweite Grenzwert, so wird mit Schritt S5 ein Wechsel in den zweiten Kühlmodus eingeleitet. In Schritt S5 wird dabei zunächst die erste Kopplungseinrichtung derart angesteuert, dass sie das Kühlvolumen einflussseitig vom Kühlkreislauf trennt. Da dabei die Umwälzeinrichtung weiterhin betrieben wird, wird im Kühlvolumen ein Unterdruck erzeugt. Dies ist genauer mit Bezug auf Fig. 1 erläutert.

In Schritt S6 wird durch eine im Kühlvolumen angeordnete Druckmesseinrichtung der Druck im Kühlvolumen erfasst. Dieser wird in Schritt S7 mit einem ersten Druckgrenzwert verglichen. Solange der erste Druckgrenzwert nicht unterschritten ist, wird das Verfahren ab Schritt S6 wiederholt.

Erst bei Unterschreiten des ersten Druckgrenzwertes durch den mit der Druckmesseinrichtung erfassten Druck erfolgt in Schritt S8 eine Ansteuerung der zweiten Kopplungseinrichtung zur ausflussseitigen Trennung des Kühlvolumens vom Kühlkreislauf. Damit ist mit Abschluss des Schrittes S8 das Kühlvolumen vollständig vom Kühlkreislauf getrennt und der Druck im Kühlvolumen ist kleiner als der erste Druckwert.

Da das Kühlvolumen nun vom Kühlkreislauf getrennt ist, kann in Schritt S9 die Umwälzeinrichtung deaktiviert werden. Dadurch kann insbesondere bei einer Kühleinrichtung, die zur Kühlung von Komponenten mit einer großen Abwärme ausgebildet ist, der Energieverbrauch im Kraftfahrzeug deutlich gesenkt werden. Nach der Deaktivierung der Umwälzeinrichtung in Schritt S9 ist der Wechsel in den zweiten Kühlmodus abgeschlossen und die Kühlung der Komponente erfolgt im Folgenden im zweiten Kühlmodus. Dabei erfolgt die Kühlung der Komponente durch Verdampfen von Kühlmittel im Kühlvolumen. Dies ist mit Bezug auf Fig. 1 näher erläutert.

Mit Schritt S10 ist erneut eine Erfassung der Sollleistung dargestellt. Selbstverständlich erfolgt eine Erfassung der Sollleistung und eine entsprechende Motorsteuerung auch während der vorangehenden und folgenden Verfahrensschritte parallel zu den gezeigten Verfahrensschritten. Zur größeren Übersichtlichkeit des Verfahrens sind die Erfassung der Sollleistung und die Motorsteuerung jedoch nur an jenen Stellen gezeigt, in denen sie für das Verfahren zur Kühlung einer Komponente wesentlich sind.

Da die Kühlung der Komponente nun im zweiten Kühlmodus erfolgt, ist die Wärmemenge, die von der Komponente abgeführt werden kann, kleiner als im ersten Kühlmodus. Wird nun die Komponente, während sie im zweiten Kühlmodus gekühlt wird, stark belastet, kann, insbesondere bei einer Komponente mit geringer thermischer Trägheit, die Temperatur der Komponente stark steigen. Daher wird in Schritt S11 die in Schritt S10 erfasste Sollleistung mit einem Maximalleistungswert verglichen. Um eine übersichtliche Darstellung des Verfahrens zu erreichen, wird im gezeigten Ausführungsbeispiel der Maximalwert derart gewählt, dass er gleich mit dem ersten Grenzwert für den Kühlparameter, also dem ersten Grenzwert für die Sollleistung, ist. Ein Überschreiten des Maximalleistungswertes durch den in Schritt S10 erfassten Sollleistungswert führt damit, wie im Folgenden erläutert, stets zu einem Wechsel im ersten Kühlmodus. Alternativ ist es selbstverständlich möglich, den Maximalleistungswert und den ersten Grenzwert unabhängig voneinander zu wählen, insbesondere um es zu ermöglichen, dass auch im zweiten Kühlmodus die Komponente kurzfristig mit einer Leistung betrieben werden kann, bei der keine dauerhafte Kühlung der Komponente im zweiten Kühlmodus möglich ist.

Wird im Schritt S11 ermittelt, dass die in Schritt S10 erfasste Sollleistung nicht größer ist als der Maximalleistungswert und damit auch nicht größer als der erste Grenzwert, so erfolgt in Schritt S12 die Steuerung des Antriebs mit dem in Schritt S10 erfassten Sollleistungswert und das Verfahren wird anschließend ab Schritt S10 fortgesetzt.

Wird in Schritt S11 ermittelt, dass der Sollleistungswert größer als der Maximalleistungswert ist, so erfolgt in Schritt S13 die Motorsteuerung mit dem Maximalleistungswert. Durch diese Begrenzung der maximalen Sollleistung, mit der der Antrieb des Kraftfahrzeugs angesteuert wird, wird wie erläutert sichergestellt, dass die Komponente weiterhin im zweiten Kühlmodus kühlbar ist, das heißt, dass während des in den folgenden Schritten durchgeführten Wechsels in den ersten Kühlmodus keine Überhitzung der Komponente erfolgen kann. Die in Schritt S13 durchgeführte Begrenzung der Sollleistung, die vom Antrieb des Kraftfahrzeugs gefordert wird, erfolgt selbstverständlich auch während der in den weiteren Schritten parallel erfolgenden weiteren Erfassung der Sollleistung und der Motorsteuerung, die nicht gezeigt sind.

Anschließend wird mit Schritt S14 der Wechsel in den ersten Kühlmodus eingeleitet. In Schritt S14 wird zunächst durch die Steuereinrichtung die erste Kopplungseinrichtung angesteuert, um einflussseitig das Kühlvolumen mit dem Kühlkreislauf zu verbinden. Aufgrund des Druckunterschieds zwischen dem Kühlvolumen und dem Kühlmittel im Kühlkreislauf beginnt, wie mit Bezug auf Fig. 1 erläutert, zusätzliches Kühlmittel aus dem Kühlkreislauf in das Kühlvolumen einzufließen.

In Schritt S15 wird über die im Kühlvolumen angeordnete Druckmesseinrichtung ein Druck im Kühlvolumen erfasst und im Schritt S16 mit einem zweiten Druckgrenzwert verglichen. Die Schritte S15 und S16 werden wiederholt, bis der erfasste Druck den zweiten Druckgrenzwert übersteigt.

Anschließend wird in Schritt S17 die zweite Kopplungseinrichtung angesteuert, um das Kühlvolumen ausflussseitig mit dem Kühlkreislauf zu verbinden. Aufgrund der Trägheit des Kühlmittels, das wie zuvor erläutert bereits in das Kühlvolumen einströmt, wird nun auch eine Strömung vom Kühlvolumen durch die zweite Kopplungseinrichtung aufgebaut. Damit ist nach Schritt S17 bereits eine anfängliche Strömung im Kühlkreislauf gegeben. In Schritt S18 wird anschließend die Umwälzeinrichtung aktiviert, um diese Strömung zu verstärken bzw. aufrecht zu erhalten. Nach der Aktivierung der Umwälzeinrichtung in Schritt S18 ist der erste Kühlmodus vollständig hergestellt und das Verfahren kann ab Schritt S2 wiederholt werden.

Vorangehend ist mit Bezug auf Fig. 3 ausschließlich eine Steuerung der Kühlung der Komponente in Abhängigkeit einer Sollleistung beschrieben. Für den Fachmann kann das Verfahren jedoch offensichtlich so weitergebildet werden, dass statt des Sollleistungswertes ein anderer Kühlparameter ausgewertet wird, oder dass ein Kühlparameter in Abhängigkeit mehrerer Parameter des Kraftfahrzeugs erfasst wird. Zudem kann offensichtlich, wie bereits mit Bezug auf Fig. 1 erläutert, das Verfahren auch so weitergebildet werden, dass verschiedene Kühlparameter ausgewertet werden, wobei für jeden der Kühlparameter getrennte Umschaltbedingungen vom ersten in den zweiten Kühlmodus bzw. vom zweiten in den ersten Kühlmodus vorliegen und es kann eine Umschaltung in eine der Richtungen bereits dann erfolgen, wenn nur eine dieser Bedingungen erfüllt ist oder Ähnliches.

## Patentansprüche

1. Verfahren zur Kühlung einer Komponente (1, 18) eines Kraftfahrzeugs (16), die thermisch mit einem mit einem flüssigen Kühlmittel gefüllten Kühlvolumen (2) gekoppelt ist,
wobei durch eine Steuereinrichtung (20) wenigstens ein Kühlparameter erfasst wird und in Abhängigkeit des Kühlparameters die Komponente (1, 18) entweder
- in einem ersten Kühlmodus gekühlt wird, in dem das Kühlvolumen (2) über eine erste und zweite Kopplungseinrichtung (7, 8) mit einem Kühlkreislauf verbunden ist, der wenigstens eine Umwälzeinrichtung (9) umfasst, durch die das Kühlmittel umgewälzt wird, oder
- in einem zweiten Kühlmodus gekühlt wird, in dem das Kühlvolumen (2) durch die erste und zweite Kopplungseinrichtung (7, 8) von dem Kühlkreislauf getrennt ist, wobei die Komponente (1,18) durch Verdampfen von Kühlmittel im Kühlvolumen (2) gekühlt wird
- **dadurch gekennzeichnet,**
- **dass** in Strömungsrichtung des Kühlmittels im ersten Kühlmodus die erste Kopplungseinrichtung (7) vor dem Kühlvolumen (2) und die zweite Kopplungseinrichtung (8) hinter dem Kühlvolumen (2) angeordnet ist, wobei bei einem Wechsel vom ersten in den zweiten Kühlmodus der Druck im Kühlvolumen (2) reduziert wird, indem zuerst die erste Kopplungseinrichtung (7) getrennt wird, wonach erst nach einem vorgegebenen Zeitraum und/oder bei Erfüllen einer vorgegebenen Trennbedingung die zweite Kopplungseinrichtung (8) getrennt wird.

2. Verfahren nach Anspruch 1,
**dadurch gekennzeichnet,**
**dass** die Komponente (1, 18) eine elektrische Komponente ist, wobei als Kühlparameter ein momentaner elektrischer Betriebsparameter der Komponente oder einer Schaltung, die die Komponente umfasst, oder ein durch die Steuereinrichtung (20) vorgegebener Sollwert für den Betriebsparameter erfasst wird.

3. Verfahren nach Anspruch 2,
**dadurch gekennzeichnet,**
**dass** als Betriebsparameter die Stromstärke eines Stomflusses durch die Komponente (1, 18) oder einen vorgegebenen Teil der Schaltung oder eine Spannung, die an der Komponente (1, 18) oder zwischen zwei vorgegebenen Punkten der Schaltung abfällt, oder eine durch die Schaltung abgegebene oder aufgenommene elektrische Leistung erfasst wird.

4. Verfahren einem der vorangehenden Ansprüche,
**dadurch gekennzeichnet,**
**dass** der Kühlparameter laufend erfasst wird und beim Überschreiten eines ersten vorgegebenen Grenzwertes durch den Kühlparameter und beim Unterschreiten des ersten oder eines zweiten vorgegebenen Grenzwertes durch die Steuereinrichtung (20) der Kühlmodus gewechselt wird.

5. Verfahren nach einem der vorangehenden Ansprüche,
**dadurch gekennzeichnet,**
**dass** die Trennbedingung das Unterschreiten eines vorgegebenen ersten Druckwertes im Kühlvolumen (2) ist.

6. Verfahren nach einem der vorangehenden Ansprüche,
**dadurch gekennzeichnet,**
**dass** in Strömungsrichtung des Kühlmittels im ersten Kühlmodus die erste Kopplungseinrichtung (7) vor dem Kühlvolumen (2) und die zweite Kopplungseinrichtung (8) hinter dem Kühlvolumen (2) angeordnet ist, wobei bei einem Wechsel von dem zweiten Kühlmodus in den ersten Kühlmodus zuerst die erste Kopplungseinrichtung (7) verbunden wird, wonach erst nach einem vorgegebenen Zeitraum und/oder bei Erfüllen einer vorgegebenen Verbindebedingung die zweite Kopplungseinrichtung (8) verbunden wird.

7. Verfahren nach Anspruch 6,
**dadurch gekennzeichnet,**
**dass** die Verbindebedingung das Überschreiten eines vorgegebenen zweiten Druckwerts im Kühlvolumen ist.

8. Verfahren nach einem der vorangehenden Ansprüche,
**dadurch gekennzeichnet,**
**dass** eine mit dem Kühlvolumen verbundene Volumenausgleichseinrichtung (12) genutzt wird, die eine Ausdehnung und/oder eine Reduzierung des Kühlvolumens (2) gegen eine vorgegebene Kraft ermöglicht.

9. Verfahren nach einem der vorangehenden Ansprüche,
**dadurch gekennzeichnet,**
**dass** im ersten Kühlmodus das Kühlmittel turbulent durch das Kühlvolumen (2) geleitet wird.

10. Kühleinrichtung zur Kühlung einer Komponente (1, 18) eines Kraftfahrzeugs (16), die thermisch mit einem mit einem flüssigen Kühlmittel gefüllten Kühlvolumen (2) der Kühleinrichtung (17) gekoppelt ist,
**dadurch gekennzeichnet,**
**dass** die Kühleinrichtung (17) zur Durchführung des Verfahrens nach einem der vorangehenden Ansprüche ausgebildet ist.

11. Kühleinrichtung nach Anspruch 10,
**dadurch gekennzeichnet,**
**dass** der Kühlkreislauf einen Ausgleichsbehälter (11) für das Kühlmittel umfasst.

12. Kühleinrichtung nach Anspruch 10 oder 11,
**dadurch gekennzeichnet,**
**dass** im Kühlvolumen (2) und/oder im Kühlkreislauf wenigstens eine Druckmesseinrichtung (15) zur Erfassung des Kühlmitteldrucks angeordnet ist.

13. Kraftfahrzeug, umfassend wenigstens eine zu kühlende Komponente
**dadurch gekennzeichnet,**
**dass** es eine Kühleinrichtung (17) nach einem der Ansprüche 10 bis 12 zur Kühlung der Komponente (1, 18) umfasst, wobei die Komponente (1, 18) thermisch mit einem mit einem flüssigen Kühlmittel gefüllten Kühlvolumen (2) der Kühleinrichtung (17) gekoppelt ist.

14. Kraftfahrzeug nach Anspruch 13,
**dadurch gekennzeichnet,**
**dass** die Komponente (1, 18) eine Leistungselektronikkomponente eines elektrischen Antriebs (19) des Kraftfahrzeugs (16) ist.

15. Kraftfahrzeug nach Anspruch 14,
**dadurch gekennzeichnet,**
**dass** die Steuereinrichtung (20) zur Begrenzung der Leistung des Antriebs (19) bei Kühlung im zweiten Kühlmodus auf einen Maximalleistungswert, der kleiner ist als ein Leistungswert, mit dem der Antrieb (19) im ersten Kühlmodus betreibbar ist, ausgebildet ist.

16. Kraftfahrzeug nach Anspruch 15
**dadurch gekennzeichnet,**
**dass** die Steuereinrichtung (20) ausgebildet ist, eine Sollleistung zu erfassen, die durch eine Fahrzeugeinrichtung, insbesondere ein fahrerseitig bedienbares Bedienelement (21) oder ein Fahrerassistenzsystem, vorgebbar ist, und bei Erfassung einer Sollleistung, die größer ist als der Maximalleistungswert, in den zweiten Kühlmodus zu schalten.

17. Kraftfahrzeug nach einem der Ansprüche 13 bis 16,
**dadurch gekennzeichnet,**
**dass** es eine Eingabeeinrichtung (22) zur Erfassung einer Benutzereingabe zur Wahl eines Fahrzeugmodus und eine Steuereinrichtung (20) umfasst, wobei die Steuereinrichtung (20) zur Bestimmung des Kühlparameters und/oder des ersten und/oder des zweiten Grenzwertes für den Kühlparameter und/oder des Maximalleistungswertes in Abhängigkeit des Fahrzeugmodus dient.

## Claims

1. Method for cooling a component (1, 18) of a motor vehicle (16) which is thermally coupled to a cooling volume (2) filled with a fluid coolant,
wherein at least one cooling parameter is detected by a control device (20) and depending upon the cooling parameter, the component (1, 18) is either cooled
- in a first cooling mode in which the cooling volume (2) is connected to a cooling circuit via a first and second coupling device (7, 8) which has at least one circulating device (9), through which the coolant is circulated, or
- the component (1, 18) is cooled in a second cooling mode in which the cooling volume (2) is separated from the cooling circuit by the first and second coupling device (7, 8), wherein the component (1, 18) is cooled by evaporating coolant in the cooling volume (2)
- **characterised in that**
- the first coupling device (7) is arranged in front of the cooling volume (2) in the flow direction of the coolant in the first cooling mode and the second coupling device (8) is arranged behind the cooling volume (2) wherein the pressure in the cooling volume (2) is reduced when changing from the first to the second cooling mode by the first coupling device (7) firstly being separated, after which only after a predefined period and/or when a predefined separation condition is filled, the second coupling device (8) is separated.

2. Method according to claim 1,
**characterised in that**
the component (1, 18) is an electric component wherein a present, electric operating parameter of the component or a circuit, comprising the component, or target value for the operating parameter predefined by the control device (20) is detected.

3. Method according to claim 2,
**characterised in that**
the current strength of a current flow through the component (1, 18) or a predefined part of the circuit or a voltage, which drops at the component (1, 18) or between two preset points of the circuit, or an electric output discharged or consumed by the circuit is detected as the operating parameter.

4. Method according to any one of the preceding claims,
**characterised in that**
the cooling parameter is detected continuously and the cooling mode is changed when a first preset limit value is exceeded by the cooling parameter and when the first or a second preset limit value is undercut by the control device (20).

5. Method according to any one of the preceding claims,
**characterised in that**
the separation condition is the undercutting of a preset first pressure value in the cooling volume (2).

6. Method according to any one of the preceding claims,
**characterised in that**
the first coupling device (7) is arranged in front of the cooling volume (2) in the flow direction of the coolant in the first cooling mode and the second coupling device (8) is arranged behind the cooling volume (2) wherein the first coupling device (7) is initially connected when the second cooling mode changes to the first cooling mode, after which only after a predefined period and/or when a predefined connection condition is fulfilled, the second coupling device (8) is connected.

7. Method according to claim 6,
**characterised in that**
the connection condition is the exceeding of a preset second pressure value in the cooling volume.

8. Method according to any one of the preceding claims,
**characterised in that**
a volume balancing device (12) connected to the cooling volume is used to enable an extension and/or a reduction of the cooling volume (2) against a predefined force.

9. Method according to any one of the preceding claims,
**characterised in that**
the coolant is guided in a turbulent manner through the cooling volume (2) in the first cooling mode.

10. Cooling device for cooling a component (1, 18) of a motor vehicle (16), which is thermally coupled to a cooling volume (2) of the cooling device (17) filled with a fluid coolant,
**characterised in that**
the cooling device (17) is configured to carry out the method according to any one of the preceding claims.

11. Cooling device according to claim 10,
**characterised in that**
the cooling circuit has an expansion tank (11) for the coolant.

12. Cooling device according to claim 10 or 11,
**characterised in that**
at least one pressure measuring device (15) is arranged in the cooling volume (2) and/or in the cooling circuit to detect the coolant pressure.

13. Motor vehicle, comprising at least one component to be cooled,
**characterised in that**
it comprises a cooling device (17) according to any one of claims 10 to 12 for cooling the component (1, 18) wherein the component (1, 18) is thermally coupled to a cooling volume (2) of the cooling device (17) filled with a fluid coolant.

14. Motor vehicle according to claim 13,
**characterised in that**
the component (1, 18) is a power electronic component of an electric drive (19) of the motor vehicle (16).

15. Motor vehicle according to claim 14,
**characterised in that**
the control device (20) is configured to limit the power of the drive (19) during cooling in the second cooling mode to a maximum power value lower than a power value by means of which the drive (19) can be operated in the first cooling mode.

16. Motor vehicle according to claim 15,
**characterised in that**
the control device (20) is configured to detect a target power which can be predefined by a vehicle device, in particular an operating element (21) operable on the driver side or a vehicle assistance system and is configured to switch to the second cooling mode when a target power greater than the maximum power value is detected.

17. Motor vehicle according to any one of claims 13 to 16,
**characterised in that**
it comprises an input device (22) for detecting a user input to select a driving mode and a control device (20) wherein the control device (20) serves to determine the cooling parameter and/or the first and/or the second limit value for the cooling parameter and/or the maximum power value depending on the driving mode.

## Revendications

1. Procédé servant à refroidir un composant (1, 18) d'un véhicule automobile (16), qui est couplé thermiquement à un volume de refroidissement (2) rempli d'un liquide de refroidissement liquide,
dans lequel au moins un paramètre de refroidissement est détecté par un dispositif de commande (20) et en fonction du paramètre de refroidissement, le composant (1, 18) est soit
- refroidi dans un premier mode de refroidissement, dans lequel le volume de refroidissement (2) est relié, par l'intermédiaire d'un premier dispositif de couplage et d'un deuxième dispositif de couplage (7, 8), à un circuit de refroidissement, qui comprend au moins un dispositif de recirculation (9), par lequel le liquide de refroidissement est remis en circulation, soit
- est refroidi dans un deuxième mode de refroidissement, dans lequel le volume de refroidissement (2) est séparé du circuit de refroidissement par le premier et le deuxième dispositif de couplage (7, 8), dans lequel le composant (1, 18) est refroidi par évaporation du liquide de refroidissement dans le volume de refroidissement (2),
- **caractérisé en ce**
- **que** le premier dispositif de couplage (7) est disposé avant le volume de refroidissement (2) et le deuxième dispositif de couplage (8), derrière le volume de refroidissement (2) dans la direction d'écoulement du liquide de refroidissement dans le premier mode de refroidissement, dans lequel lors d'un changement du premier au deuxième mode de refroidissement, la pression est réduite dans le volume de refroidissement (2), en ce que dans un premier temps le premier dispositif de couplage (7) est séparé, le deuxième dispositif de couplage (8) étant séparé par la suite seulement après un laps de temps prédéfini et/ou lorsqu'une condition de séparation prédéfinie est remplie.

2. Procédé selon la revendication 1,
**caractérisé en ce**
**que** le composant (1, 18) est un composant électrique, dans lequel un paramètre de fonctionnement électrique instantané du composant ou d'un circuit, qui comprend le composant, ou une valeur théorique prédéfinie par le dispositif de commande (20) est détecté/détectée pour le paramètre de fonctionnement en tant que paramètre de refroidissement.

3. Procédé selon la revendication 2,
**caractérisé en ce**
**que** sont détectées en tant que paramètres de fonctionnement l'intensité d'un flux de courant à travers le composant (1, 18) ou une partie prédéfinie du circuit ou une tension, qui chute au niveau du composant (1, 18) ou entre deux points prédéfinis du circuit, ou une puissance électrique fournie ou absorbée par le circuit.

4. Procédé selon l'une quelconque des revendications précédentes,
**caractérisé en ce**
**que** le paramètre de refroidissement est détecté en continu, et le mode de refroidissement est changé lorsqu'une première valeur limite prédéfinie est dépassée par le paramètre de refroidissement et lorsque la première ou une deuxième valeur limite prédéfinie n'est pas atteinte par le dispositif de commande (20).

5. Procédé selon l'une quelconque des revendications précédentes,
**caractérisé en ce**
**que** la condition de séparation est le fait de ne pas atteindre une première valeur de pression prédéfinie dans le volume de refroidissement (2).

6. Procédé selon l'une quelconque des revendications précédentes,
**caractérisé en ce**
**que** le premier dispositif de couplage (7) est disposé avant le volume de refroidissement (2) et le deuxième dispositif de couplage (8), derrière le volume de refroidissement (2) dans la direction d'écoulement du liquide de refroidissement dans le premier mode de refroidissement,
dans lequel lors d'un changement du deuxième mode de refroidissement au premier mode de refroidissement, le premier dispositif de couplage (7) est relié dans un premier temps, le deuxième dispositif de couplage (8) étant relié par la suite seulement après un laps de temps prédéfini et/ou lorsqu'une condition de liaison prédéfinie est remplie.

7. Procédé selon la revendication 6,
**caractérisé en ce**
**que** la condition de liaison est le dépassement d'une deuxième valeur de pression prédéfinie dans le volume de refroidissement.

8. Procédé selon l'une quelconque des revendications précédentes,
**caractérisé en ce**
**qu'**un dispositif de compensation de volume (12) relié au volume de refroidissement est utilisé, lequel permet une extension et/ou une réduction du volume de refroidissement (2) à l'encontre d'une force prédéfinie.

9. Procédé selon l'une quelconque des revendications précédentes,
**caractérisé en ce**
**que** le liquide de refroidissement est acheminé de manière turbulente à travers le volume de refroidissement (2) dans le premier mode de refroidissement.

10. Dispositif de refroidissement servant à refroidir un composant (1, 18) d'un véhicule automobile (16), qui est couplé thermiquement à un volume de refroidissement (2), rempli d'un liquide de refroidissement liquide, du dispositif de refroidissement (17),
**caractérisé en ce**
**que** le dispositif de refroidissement (17) est réalisé afin de mettre en oeuvre le procédé selon l'une quelconque des revendications précédentes.

11. Dispositif de refroidissement selon la revendication 10,
**caractérisé en ce**
**que** le circuit de refroidissement comprend un contenant de compensation (11) pour le liquide de refroidissement.

12. Dispositif de refroidissement selon la revendication 10 ou 11,
**caractérisé en ce**
**qu'**au moins un dispositif de mesure de pression (15) servant à détecter la pression de liquide de refroidissement est disposé dans le volume de refroidissement (2) et/ou dans le circuit de refroidissement.

13. Véhicule automobile, comprenant au moins un composant à refroidir,
**caractérisé en ce**
**qu'**il comprend un dispositif de refroidissement (17) selon l'une quelconque des revendications 10 à 12 servant à refroidir le composant (1, 18), dans lequel le composant (1, 18) est couplé thermiquement à un volume de refroidissement (2), rempli d'un liquide de refroidissement liquide, du dispositif de refroidissement (17).

14. Véhicule automobile selon la revendication 13,
caractérisé e ce
que le composant (1, 18) est un composant électronique de puissance d'un entraînement (19) électrique du véhicule automobile (16).

15. Véhicule automobile selon la revendication 14,
**caractérisé en ce**
**que** le dispositif de commande (20) est réalisé afin de limiter la puissance de l'entraînement (19) lors du refroidissement dans le deuxième mode de refroidissement à une valeur de puissance maximale, qui est inférieure à une valeur de puissance, à laquelle l'entraînement (19) peut fonctionner dans le premier mode de refroidissement.

16. Véhicule automobile selon la revendication 15,
**caractérisé en ce**
**que** le dispositif de commande (20) est réalisé afin de détecter une puissance théorique, qui peut être prédéfinie par un dispositif de véhicule, en particulier un élément d'utilisation (21) pouvant être utilisé du côté du conducteur ou un système d'aide au conducteur, et pour commuter dans le deuxième mode de refroidissement lors de la détection d'une puissance théorique, qui est supérieure à la valeur de puissance maximale.

17. Véhicule automobile selon l'une quelconque des revendications 13 à 16,
**caractérisé en ce**
**qu'**il comprend un dispositif d'entrée (22) servant à détecter une entrée d'utilisateur servant à choisir un mode de véhicule et un dispositif de commande (20), dans lequel le dispositif de commande (20) sert à déterminer le paramètre de refroidissement et/ou la première et/ou la deuxième valeur limite pour le paramètre de refroidissement et/ou la valeur de puissance maximale en fonction du mode de véhicule.
